# EUROPEAN PATENT APPLICATION

(11) **EP 4 174 915 A1**
(43) Date of publication of application: **03.05.2023**
(21) Application number: 22198683.9
(22) Date of filing: 29.09.2022
(51) Int. Cl.: H01L 21/306

(54) **CMP PROCESS APPLIED TO A THIN SIC WAFER FOR STRESS RELEASE AND DAMAGE RECOVERY**

(30) Priority: 26.10.2021 IT 202100027467
(71) Applicant: STMicroelectronics S.r.l., 20864 Agrate Brianza (MB) (IT)
(72) Inventor: GRASSO, Agata, 95030 TREMESTIERI ETNEO (CT) (IT); PILUSO, Nicolò, 95124 CATANIA (IT); SEVERINO, Andrea, 95025 ACI SANT'ANTONIO (CT) (IT); CAFRA, Brunella, 95030 MASCALUCIA (CT) (IT)
(74) Representative: Studio Torta S.p.A.

(57) **Abstract**

A Chemical Mechanical Polishing, CMP, process applied to a wafer (20) of Silicon Carbide having a thickness of, or lower than, 200µm, comprising the steps of: arranging the wafer (20) on a supporting head (14) of a CMP processing apparatus (10), the wafer (20) having a front side (20a) and a back side (20b) opposite to one another, the front side (20a) housing at least one electronic component and being coupled to the supporting head (14); deliver a polishing slurry on the wafer (20), wherein the polishing slurry has a pH in the range 2-3; pressing the back side (20b) of the wafer (20) against a polishing pad (16) of the CMP apparatus (10) exerting, by the supporting head (14), a pressure on the polishing pad (16) in the range 5-20 kPa; setting a rotation of the polishing pad (16) in the range 30-180 rpm, and setting a rotation of polishing head (14) in the range 30-180 rpm; setting and maintaining a CMP process temperature equal to, or below, 50°C.

## Description

The present invention relates to a Chemical Mechanical Polishing, CMP, process applied to a thin wafer of Silicon Carbide, in particular having a thickness of, or lower than, 180µm. The CMP process is aimed at releasing the stress of thinned wafers and recovering surface damages or cracks. The CMP process is carried out at the back side of SiC wafers having a front side already processed (i.e., with electronic components integrated at the front side).

Integrated circuits are known to be manufactured by alternated steps of deposition and removal of layers belonging to a Silicon and Silicon Carbide wafers; such layers may be either conductive, semiconductive or insulating.

One manufacturing step involves wafer thinning to guarantee optimal device performances, typically a reduction of the electrical resistance when the device is conducting (Rₒₙ resistance). The thinning process is usually performed by mechanical abrasion of a substrate (grinding process).

On SiC wafers, the grinding process may cause deep sub-surface damage (SSD), with cracks and dislocations, that extends in depth through the Silicon Carbide surface for 1-3 µm.

Wafer warpage, caused by a compressive stress on the wafer surface, is also a direct consequence of a thinning process by grinding techniques. Stress induced by thinning process and the persistence of cracks increase wafer warpage and makes the dies thus manufactured fragile, impacting mechanical strength and die yield.

A stress relief step able to recover the original (pre-grinding) wafer surface and hence to recover the wafer warpage to the original, pre-grinding , values, is required to improve Silicon Carbide material quality and consequently the electrical and mechanical quality of the devices integrated therein.

The present Applicant investigated the use of a thermal process (annealing) to recover the grinding damages; however, this solution is not satisfactory due to thermal constraints that, in some situations (namely, when the wafer has already been processed to manufacture, at least in part, of electronic devices), limit the temperatures below 1000 °C. This thermal budget is not able to guarantee the SiC wafer surface recovery.

Same considerations can be done for laser annealing that allows local surface heating of the wafer; the thermalinduced stress by laser irradiation is responsible for crystal rearrangement, with new crystal defect and possible cracks creation due to the thermal gradient crated during laser processing between an annealed (thermally stressed) region and a not annealed region.

Therefore, stress release is a particularly critical step for SiC wafers, having low fracture toughness and extreme brittleness, high hardness and a remarkable chemical inertness. These issues become more serious with SiC substrate having reduced thickness (for example under 180 µm).

The paper by CHEN GUOMEI et al, "The Effect of Surface Polarity on the CMP Behavior of 6H-SiC Substrates," Russian Journal of Applied Chemistry, vol. 93, no. 6, June 1, 2020, pp. 832-837, XP037195431, discusses the performance of the CMP technique in Silicon and 6H-SiC substrates.

Document US2016/133465 describes a method of producing a SiC substrate including a CMP step.

Document CN105470122 relates to a method of reducing the thickness of a SiC wafer.

However, the above-mentioned problems remain unresolved.

The aim of the present invention is to provide a CMP process applied to a thin wafer of Silicon Carbide, that overcome the drawbacks mentioned above.

According to the present invention a CMP process applied to a wafer of Silicon Carbide is provided, as defined in the annexed claims.

For a better understanding of the invention, some embodiments thereof will now be described, purely by way of non-limiting example and with reference to the attached drawings, wherein:
- Figure 1 shows a schematic implementation of a CMP apparatus; and
- Figure 2 shows a portion of a wafer during the CMP processing according to the present invention.

In an embodiment of the present invention, a CMP (Chemical-Mechanical_Polishing) process is proposed for overcoming the limitations of the known art.

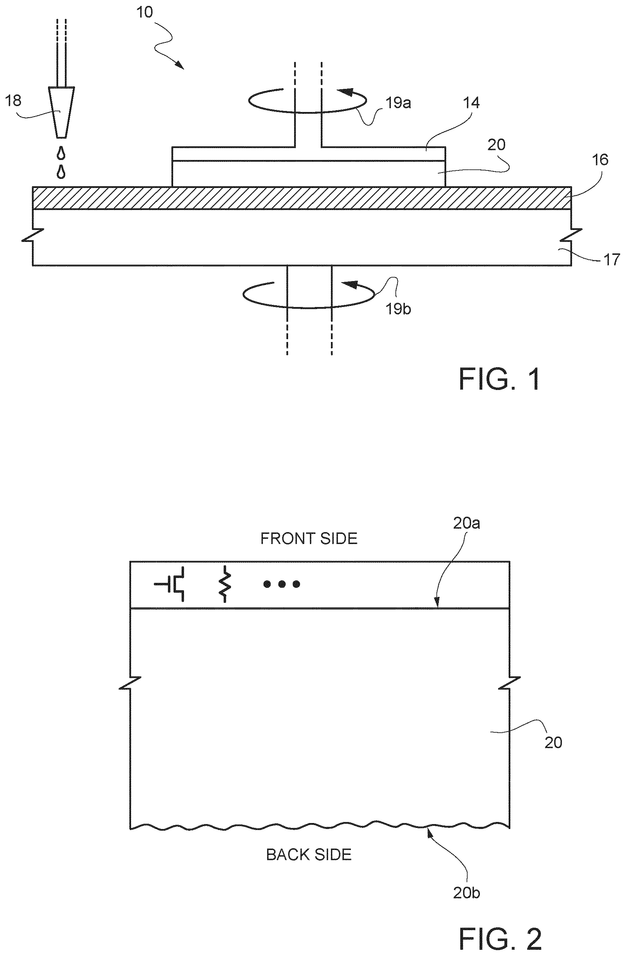

With reference to Figure 1, a CMP apparatus 10 is schematically shown.

The CMP apparatus 10 comprises, in a per se known way, a polishing head 14, configured to support or carry or hold a wafer 20 (here, of Silicon Carbide, in particular 4H-SiC) during the CMP process. A polishing pad 16 is arranged over a supporting platen 17. The polishing pad 16 is, for example, of polyurethane. The polishing head 14 and the polishing pad 16 faces one another.

Both the polishing head 14 and the platen 17 are controllable in rotation, as exemplified by arrows 19a, 19b, for performing the CMP process. The rotation of the platen 17 causes a corresponding rotation of the polishing pad 16, and the rotation of the polishing head 14 causes a corresponding rotation of the wafer 20.

A slurry delivery system 18 is also provided, configured to provide a substantially uniform slurry layer (i.e., the chemical-mechanical abrasive) onto the polishing pad 16, in a per se known way. After-polishing detection and process control equipment, waste treatment and testing equipment, etc., may also be part of the CMP apparatus 10.

The SiC wafer 20 to be processed has a front side 20a and a back (or bottom) side 20b, opposite to one another. As better discussed in the following, the front side 20a has already been processed to manufacture one or more electronic devices, or parts therefor, for example by implanting dopant species, growing or depositing conductive (e.g., of metal material) or insulating layers, etc. The back side 20b has been subject to a grinding process, to reduce the thickness of the wafer 20 down to 200 µm or less. The CMP process according to the present description is applied to the bottom side 20b.

During the CMP process, the wafer 20, supported/held by the polishing head 14 at the front side 20a, is pressed, by the polishing head 14, against the polishing pad 16 to process the surface 20b. In particular, the wafer 20 is of Silicon Carbide (SiC) and has a thickness of, or below, 180µm, e.g. between 40 and 180 µm, and more in particular 100 µm. Usually, SiC wafers 20 are manufactured with a thickness of about 350-500 µm; to achieve the thickness of 180 µm or less, a grinding step is carried out, as previously discussed.

As shown in Figure 2, the front side 20a of the wafer 20 may be already processed to form, at least in part, electronic components or devices, or any other electrical structure. A back side 20b of the wafer 20 is the side processed by the grinding process (and therefore presenting defects/cracks as a consequence of the grinding process), and to be further processed by the CMP process according to the present invention.

The CMP process according to the present invention is carried out with the following parameters / settings.

### Polishing pad speed and wafer speed.

Polishing pad speed can affect the entering and leaving of chemical products and reactants between the wafer 20 and the polishing pad 16. The wafer speed will affect the speed of the abrasives through the wafer 20.

The speed of rotation of the polishing pad is set in the range 30-180 rpm, more in particular between 30 and 70 rpm.

The speed of wafer rotation is defined by the speed of rotation of the support carried 14, and is set in the range 30- 180 rpm, more in particular between 30 and 60 rpm.

In one embodiment, the wafer 20 (i.e., the carrier 14) and the polishing pad 16 turn to the same direction of rotation; other embodiments, where the wafer 20 (i.e., the carrier 14) and the polishing pad 16 turn to the opposite direction are possible.

### Polishing pressure.

Pressure is exerted by the polishing head 14 on the polishing pad 16, with the wafer 20 there between.

In this process, the pressure exerted on different areas of the surface 20b of the wafer 20 could, but not necessarily, be different.The pressure is set in the range between 5 and 20 kPa.

### Polishing time and material removal rate.

Polishing time impact on the material removal rate. The selection of polishing time is according to processing quality requirement and / or quantity (thickness) of material to be removed. If polishing time is too long, the abrasives in polishing slurries may lead to secondary injury to the processed surface.

The thickness of SiC removed at the back side 20b is, in one embodiment, in the range 1-3 µm; accordingly, polishing time / removal rate are set accordingly to achieve this objective.

The present Applicant found that removing about 3 µm of SiC material is enough to remove all defects and cracks at the treated surface (in this example, surface 20b).

### Type of slurry.

The abrasive slurry is chosen based on its pH property. In the present process, the slurry is chosen with a pH in the range 2-3 (acid).

The slurry flow rate is, in one possible embodiment, less than 100 ml/min.

Removal rate can be set freely, for example equal to, or higher than 10µm/hr. Lower removal rates (e.g., around 6pm/hr are possible).

Exemplary slurry include, for example, alumina-based polishing slurries specifically formulated for the chemical mechanical planarization of Silicon Carbide wafers. These slurries, which are known in the art and commercially available, are formulated with permanganate oxidizers, tightly sized engineered nano-particles, and accelerant chemistries that facilitate very low surface finish, defectivity and sub-surface damage on SiC surfaces.

Other types of slurries can be used.

### Process temperature.

The CMP process temperature (i.e., temperature of the polishing pad 16) is maintained below 50°C, in particular between ambient temperature (around 24°C) and 50°C.

With the above parameters, the Applicant found that the issues of the known art are overcome.

In particular, cracks and damages at wafer's surface are recovered (eliminated). Furthermore, wafer warpage at the end of the CMP process is found to be substantially equal to the original wafer warpage, i.e. before the thinning step performed through grinding.

Surface quality is improved with the present CMP process. The appropriate balance between chemical and mechanical factors can reduce the wafer's roughness so as to obtain higher surface shape precision and ensure the desired surface quality. The wafer surface 20b after CMP can be inspected through profile testing and its surface roughness can be measured by large area surface profilometer. For the surface quality testing of the wafer, several indexes can be measured. For example, the following parameters have been exemplarily measured: Sa or arithmetical mean height < 2 nm; Sq or root mean square height < 10 nm; Sz or maximum height < 2 nm.

The advantages achieved by the present invention are apparent from the above description.

The invention proposes a way to solve the difficulty to perform a proper stress relief process after SiC wafers grinding (<180 um) due to the high chemical inertness of SiC. The proposed solution, based on a chemical mechanical surface planarization stress relief process, has demonstrated to be effective on warpage/stress recovery, on surface recovery and mechanical yield. The CMP process step can be performed during a device fabrication process flow, after a grinding step, to recover the damages of the grinding step, thus increasing device yield.

Finally, it is evident that modifications and variations may be made to the present disclosure, without departing from the scope of the invention, as defined in the annexed claims.

For example, the CMP process described above can be applied on a SiC wafer that is temporarily bonded to a support wafer, which is useful in case of SiC wafer having low thickness, and therefore being fragile and/or difficult to handle.

## Claims

1. A Chemical Mechanical Polishing, CMP, process applied to a wafer (20) of Silicon Carbide having a thickness of, or lower than, 180pm, comprising the steps of:
- arranging the wafer (20) on a supporting head (14) of a CMP processing apparatus (10), the wafer (20) having a front side (20a) and a back side (20b) opposite to one another, wherein at least one electronic component is present at the front side (20a), and wherein the front side (20a) is coupled to the supporting head (14);
- deliver a polishing slurry on the wafer (20), wherein the polishing slurry has a pH in the range 2-3;
- pressing the back side (20b) of the wafer (20) against a polishing pad (16) of the CMP apparatus (10) exerting, by the supporting head (14), a pressure on the polishing pad (16) in the range 5-20 kPa;
- setting a rotation of the polishing pad (16) in the range 30-180 rpm, and setting a rotation of polishing head (14) in the range 30-180 rpm;
- setting and maintaining a CMP process temperature equal to, or below, 50°C.

2. The CMP process of claim 1, wherein the flow rate of the polishing slurry is less than 100 ml/min.

3. The CMP process of claim 1 or claim 2, wherein the polishing slurry is alumina-based.

4. The CMP process of anyone of the preceding claims, wherein the CMP process is executed until a thickness between 1 and 3 µm of material is removed from the back side (20b) of the wafer (20).

5. The CMP process of anyone of the preceding claims, wherein the direction of rotation of the polishing pad (16) is the same to the rotation of the supporting head (14).

6. The CMP process of anyone of the preceding claims, wherein the rotation of the polishing pad (16) is set in the range 30-70 rpm, and the rotation of polishing head (14) is set in the range 30-60 rpm.

7. The CMP process of anyone of the preceding claims, wherein the wafer (20) is of 4H-Silicon Carbide, 4H-SiC.
